# EUROPÄISCHE PATENTSCHRIFT

(11) **EP 1 422 194 B1**
(45) Veröffentlichungstag und Bekanntmachung des Hinweises auf die Patenterteilung: **10.01.2007**
(21) Anmeldenummer: 02079901.1
(22) Anmeldetag: 25.11.2002
(51) Int. Cl.: B81C 1/00, B29C 45/03, B29C 33/38, B23P 15/00, B29C 33/00, B29C 33/42

(54) **Verfahren zur Herstellung eines Werkzeugeinsatzes zum Spritzgiessen eines mikrostrukturierten Teils**
Process to fabricate a Tool Insert for Injection Moulding a microstructured Piece
Procéde de fabrication d'un moule pour le coulage par injection d'une pièce microstructurée

(43) Veröffentlichungstag der Anmeldung: 26.05.2004
(73) Patentinhaber: Weidmann Plastics Technology AG, 8640 Rapperswil (CH)
(72) Erfinder: Fässler, Thomas, 8634 Hombrechtikon (CH); Gmür, Max, 9607 Mosnang (CH)
(74) Vertreter: Ventocilla, Abraham

(56) Entgegenhaltungen:
- US-A- 5 618 567
- US-A1- 2002 098 611
- US-B1- 6 242 163
- OLSSON A ET AL: "Valve-less diffuser micropumps fabricated using thermoplastic replication" MICRO ELECTRO MECHANICAL SYSTEMS, 1997. MEMS ' 97, PROCEEDINGS, IEEE., TENTH ANNUAL INTERNATIONAL WORKSHOP ON NAGOYA, JAPAN 26-30 JAN. 1997, NEW YORK, NY, USA,IEEE, US, 26. Januar 1997 (1997-01-26), Seiten 305-310, XP010216923 ISBN: 0-7803-3744-1

## Beschreibung

Die Erfindung betrifft ein Verfahren zur Herstellung eines Werkzeugeinsatzes zum Spritzgiessen eines mikrostrukturierten Teils, welches aus einem Kunststoff, einem Metall oder aus einem keramischen Material hergestellt wird und welches eine Anordnung von Mikrokanälen aufweist, die auf einer im wesentlichen ebene Aussenfläche gebildet werden, und eine Anordnung von Durchgangslöchern aufweist, die sich im wesentlichen senkrecht zur Aussenfläche des Teils erstrecken.

US-A-20020098611 beschreibt ein Verfahren zur Herstellung integrierter, passiver Komponenten für HF-Nachrichtenübertragung. Hierzu wird die Vorderseite eines Siliziumwafers maskiert und mittels Plasmaätzen Strukturen im Siliziumwafer gebildet. Die Maskierung wird entfernt und elektrochemisch eine Metallschicht auf die Vorderseite des Siliziumwafers und in die darin vorhandenen Strukturen abgeschieden. Die Metallschicht wird planarisiert und vom Siliziumwafer getrennt.

Die Erfindung betrifft ausserdem ein Verfahren zum Spritzgiessen eines Teils, welches aus einem Kunststoff, einem Metall oder aus einem keramischen Material hergestellt wird und welches eine Anordnung von Mikrokanälen aufweist, die auf einer im wesentlichen ebene Aussenfläche gebildet werden, und eine Anordnung von Durchgangslöchern aufweist, die sich im wesentlichen senkrecht zur Aussenfläche des Teils erstrecken, wobei ein Werkzeug zum Spritzgiessen verwendet wird, das von einer ersten und einer zweiten Werkzeughälfte gebildet wird.

US-A-5618567 beschreibt ein Verfahren zum Spritzgiessen eines mehrschichtigen Teils aus Harz, welches eine Anordnung von Durchgangslöchern aufweist, welche sich im wesentlichen senkrecht zur Aussenfläche des Teils erstrecken, wobei ein Werkzeug zum Spritzgiessen verwendet wird, welches von einer ersten und zweiten Werkzeughälfte gebildet wird. Das Verfahren umfasst folgende Verfahrensschritte: Schliessen des von der ersten und zweiten Werkzeughälfte gebildeten Werkzeugs, wobei die zweite Werkzeughälfte Stifte aufweist, welche die genannten Durchgangslöcher bewirken. Das geschmolzene Harz wird in den Raum zwischen dem ersten und zweiten Werkzeugeinsatz eingespritzt, das eingespritzte Harz wird abkühlen gelassen und das hergestellte Produkt aus dem Werkzeug ausgestossen.

Der Artikel 'Valve-Less Diffuser Micropumps Fabricated Using Thermoplastic Replication' von Olsson et al. (Micro electro Mechanical Systems, 1997. MEMS' 97, Proceedings, IEEE., Tenth Annual International Workshop On Nagoya, Japan 26-30 Jan. 1997, New York, NY, USA, IEEE, US, XP010216923 ISBN: 0-7803-3744-1) offenbart ein Verfahren zur Herstellung einer Mikropumpe. Dazu werden mittels Trockenätzen in einem Plasma (DRIE=Deep Reactive Ion Etching) die Strukturen der Mikropumpe in einen Siliziumwafer geätzt. Die geätzte Struktur wird mit Nickel beschichtet und die Nickelbeschichtung als Werkzeugeinsatz in ein Spritzgusswerkzeug zum Spritzgiessen der Mikropumpe mit Polykarbonat eingelegt.

Teile der oben erwähnten Art, welche fluidische Kanäle enthalten, benötigen Durchgangslöcher, damit die Flüssigkeit zugeführt und entnommen werden kann. Durchgangslöcher können nach dem Spritzgiessen durch mechanische Verfahren in das Teil eingearbeitet werden. Viel effizienter ist aber die Durchgangslöcher bereits beim Spritzgiessen zu erzeugen. Dazu werden an den Stellen, wo das Teil ein Durchgangsloch aufweisen soll, in beiden Werkzeughälften Stifte (nachfolgend Lochstempel genannt) eingesetzt, wobei immer zwei einander gegenüberliegende Lochstempel beim Schliessen der beiden Werkzeughälften aufeinander drücken (nachfolgend quetschen genannt). Beim anschliessenden Einspritzen der Materialschmelze, z.B. der Kunststoffschmelze, formen sich bei den Lochstempeln Durchgangslöcher aus.

Im Mikrospritzguss sind die Anforderungen an die Einpassgenauigkeit der Lochstempel in die Werkzeuge, insbesondere auf der mikrostrukturierten Werkzeughälfte, sehr viel hoher als im konventionellen Spritzguss, denn um die Mikrostrukturen formtreu abzubilden muss die Materialschmelze sehr niedrige Viskosität aufweisen, dies erhöht aber die Gefahr , dass die Materialschmelze zwischen Lochstempel und Werkzeug in die Passung eindringt und dort einen Brauen bildet. Dieser Brauen kann dazu führen, dass die Verbindung vom Durchgangsloch zum Mikrokanal teilweise oder vollständig verschlossen ist und so den Mikrokanal und das gesamte Teil unbrauchbar macht. Erschwerend kommt dazu, dass die Durchgangslöcher bei mikrostrukturierten Teilen ebenfalls klein sein müssen, einerseits damit sie nicht unnötig Platz beanspruchen, andererseits damit sie sehr kleine Flüssigkeitsvolumina aufnehmen. Entsprechend hoher ist der Herstellaufwand. Einpasslöcher für Lochstempel mit einem Durchmesser kleiner als 1 Millimeter können zum jetzigen Zeitpunkt in der geforderten Präzision nur mit grossem Aufwand und Kosten hergestellt werden.

Der Erfindung liegt daher die erste Aufgabe zugrunde ein Verfahren zur Herstellung eines mikrostrukturierten Werkzeugeinsatzes der oben erwähnten Art zur Verfügung zu stellen, mit dem die Mängel der oben erwähnten Verfahren behoben werden.

Gemäss einem ersten Aspekt der Erfindung wird diese erste Aufgabe mit einem Verfahren gemäss Anspruch 1 gelöst. Bevorzugte Ausführungsformen sind durch Unteransprüche definiert.

Der Erfindung liegt ferner die zweite Aufgabe zugrunde ein Verfahren zum Spritzgiessen eines Teils zur Verfügung zu stellen, welches aus einem Kunststoff, einem Metall oder aus einem keramischen Material hergestellt wird und welches eine Anordnung von Mikrokanälen aufweist, die auf einer im wesentlichen ebene Aussenfläche gebildet werden, und eine Anordnung von Durchgangslöchern aufweist, die sich im wesentlichen senkrecht zur Aussenfläche des Teils erstrecken.

Gemäss einem zweiten Aspekt der Erfindung wird diese zweite Aufgabe mit einem Verfahren gemäss Anspruch 7 gelöst.

Die mit den erfindungsgemässen Verfahren erzielten Vorteile sind insbesondere wie folgt:

Mit dem erfindungsgemässen Verfahren werden die Lochstempel in einem mikrostrukturierten Werkzeugeinsatz integriert. Damit entfällt ein Übergang zum Mikrokanal und Werkzeug in Form eines Spaltes und es besteht überhaupt keine Gefahr von Brauenbildung zwischen Lochstempel und Mikrokanal respektiv Werkzeugeinsatz. Auf diese Weise hergestellte Lochstempel nennt man integrierte Lochstempel da sie integrale Teile des Werkzeugeinsatzes sind. Derartige integrierte Lochstempel können erfindungsgemäss in beliebigen Formen und beliebig klein hergestellt werden. Da sie im Batchverfahren erzeugt werden, können beliebig viele integrierte Lochstempel gleichzeitig hergestellt werden, was sich sehr vorteilhaft auf Durchlaufzeit, Qualität und Kosten auswirkt. Erfindungsgemäss werden zur Herstellung des mikrostrukturierten Werkzeugeinsatzes lithografische, chemische und physikalische Mikrostrukturierverfahren verwendet, welche Batchprozesse sind. Die meisten mechanischen Strukturierverfahren (z.B. bohren, fräsen, schleifen) laufen hingegen sequentiell ab, was insbesondere bei grosser Anzahl Strukturen zeitlich sehr ins Gewicht fällt und sich in Bezug auf Durchlaufzeit, Qualität und Kosten negativ auswirkt.

Die Erfindung wird nachfolgend anhand eines in den beiliegenden Zeichnungen dargestellter Ausführungsbeispiels näher erläutert. In den beiliegenden Zeichnungen zeigen
Fig. 1 die Mikrostrukturierung der Vorderseite eines ersten Wafers mittels Plasmaätzen zur Bildung einer Anordnung von Mikrokanälen durch Trenchetching,
Fig. 2 die Mikrostrukturierung der Rückseite des ersten Wafers in Fug. 1 mittels Plasmaätzen zur Bildung einer Anordnung von zur Bildung einer Anordnung von Durchgangslöchern durch Throughetching,
Fig. 3 das elektrochemisches Abscheiden einer Metallschicht auf der Vorderseite des ersten Wafers und in den darin vorhandenen Durchgangskanälen,
Fig. 4 die vom ersten Wafer und einem damit gebondeten Trägersubstrat abgetrennte Metallschicht,
Fig. 5 die Verwendung einer vom ersten Wafer und vom damit gebondeten Trägersubstrat abgetrennten Metallschicht als formgebendes Teil eines erfindungsgemäss hergestellten Werkzeugeinsatzes, der in eine Werkzeughälfte eingebaut ist, welche zu einem Werkzeug zum Spritzgiessen eines Teils gehört.
Fig. 6 das Einspritzen einer Materialschmelze in den Raum zwischen der unteren und der oberen Werkzeughälfte eines Werkzeugs zum Spritzgiessen eines Teils,
Fig. 7 das aus dem Spritzgusswerkzeug ausgestossenen Teil.

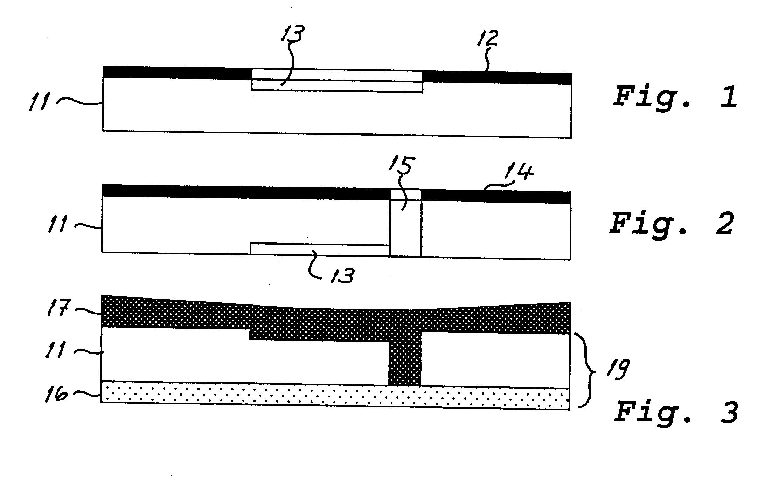

Anhand der Figuren 1 bis 4 wird nachstehend ein Verfahren zur Herstellung eines mikrostrukturierten Werkzeugeinsatzes welcher aus einem Metall oder aus einem keramischen Material hergestellt wird.

Wie in Fig. 1 gezeigt, wird die Vorderseite eines Silizium-Wafers 11 photolithografisch mit einer Ätzmaskierung 12 maskiert und anschliessend mittels Trockenatzen in einem Plasma (Fachbegriff: DRIE= Deep Reactive Ion Etching) bestehend aus Ionen und reaktiven Fluor Radikalen bis zur gewünschter Tiefe strukturiert (nachfolgend Trenchetching genannt), wobei die Fluor Radikale das Silizium abtragen. Mittels Trenchetching wird auf diese Weise eine Anordnung von Mikrokanälen 13 auf der Vorderseite des Silizium-Wafers 11 erzeugt. Die Mikrokanäle 13 haben z.B. eine Tiefe von 50 Mikrometer. Der Silizium-Wafer 11 hat z.B. eine Dicke von 250 Mikrometer.

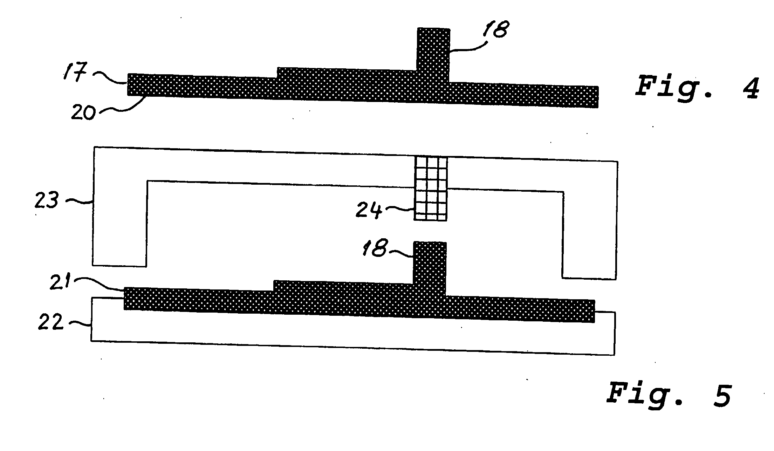

Wie in Fig. 2 gezeigt, wird anschliessend auf der eben mikrostrukturierten Vorderseite des Silizium-Wafers 11 die Ätzmaskierung 12 entfernt, der Wafer 11 gewendet, auf der Rückseite des Silizium-Wafers 11 erneut photolithografisch mit einer Ätzmaskierung 14 maskiert und anschliessend mittels Trockenatzen nach der oben beschriebenen Methode strukturiert, wobei dieses Mal die Strukturen durch den Wafer 11 hindurch getrieben werden (nachfolgend Throughetching genannt) und so eine Anordnung von Durchgangskanälen 15 erzeugt, welche den zu bildenden, integrierten Lochstempeln entsprechen.

Danach wird die Ätzmaskierung 14 entfernt und der nun fertig strukturierte Wafer 11 auf ein Trägersubstrat 16 gebondet um die Eigenstabilität zu erhöhen und die Rückseite des Wafers 11 für das elektrochemische auftragen von Nickel zu versiegeln. Durch dieses Bonden vom Wafer 11 und Trägersubstrat 16 wird ein sogenannter Galvano-Master 19 gebildet.

Als Trägersubstrat 16 eignen sich sowohl Pyrex-Wafer (Glas mit hohem Anteil an Natrium) als auch Silizium-Wafer.

Pyrex-Wafer werden mittels anodisch Bonding mit dem mikrostrukturierten Silizium-Wafer untrennbar verbunden. Beim anodisch Bonding wird eine Hochspannung von z.B. 1000 V an die aufeinander gelegten Silizium und Pyrex-Wafer angelegt. Dabei diffundieren Natrium Ionen vom Pyrex in das Silizium und erzeugen eine hochfeste ionische Verbindung zwischen Pyrex und Silizium. Die Diffusion wird zusätzlich beschleunigt durch Erhöhung der Wafertemperatur auf z.B. 400°C).

Silizium-Wafer werden mittels Silicon Fusion Bonding mit dem mikrostrukturierten Silizium-Wafer untrennbar verbunden. Beim Silizium Fusion Bonding werden die zu verbindenden Oberflachen von Silizium Substrat und mikrostrukturiertem Silizium-Wafer konditioniert und anschliessend unter Druck und Temperatur miteinander kovalent verbunden, vorausgesetzt die beiden zu verbindenden Oberflachen weisen sehr geringe Rauhigkeit auf(kleiner als 1 Nanometer), damit die beiden Oberflachen unmittelbar miteinander in Kontakt treten.

Als nächster Verfahrensschritt wird das mikrostrukturierte Silizium-Wafer 11 mit dem Trägersubstrat 16, zusammen Master 19 genannt, mit einer leitenden Dünnschicht versehen, die als Startschicht für die nachstehend beschriebene elektrochemische Abscheidung dient. Als solche eignen sich z.B. Gold, Silber und Nickel die physikalisch mittels dem Sputter- (auch bekannt unter dem Begriff Kathodenzerstäubung) oder Aufdampfverfahren nach Beschichtung mit einer Haftschicht aus Aluminium, Titan oder Chrom aufgebracht werden.

Wie in Fig. 3 gezeigt, wird anschliessend der Master 19 via die leitende Startschicht elektrisch kontaktiert und elektrochemisch eine dicke Metallschicht 17, vorzugsweise eine Nickelschicht abgeschieden, um eine mechanisch stabile Backplate zu bilden, die eine relativ hohe Festigkeit bzw. Härte aufweist. Um die Härte der Metallschicht 17 zu Erhöhen bei gleichzeitiger Erhaltung der Duktilität der Nickelschicht sind im Elektrolyt ca. 10% Kobalt enthalten. Auf diese Weise lassen sich Nickel Härten von 46- 60 HRC (Härte Rockwell C) erreichen. Eine möglichst harte Metallschicht 17 ist erforderlich, weil diese für ihre vorgesehene Funktion eine hohe Festigkeit aufweisen soll.

Nach der oben erwähnten Abscheidung von z.B. einer Nickelschicht 17, auch Nickel Schim genannt, wird zuerst die Ruckseite 20 des Nickel Shims planarisiert. Dazu eignet sich erodieren und schleifen. Anschliessend muss der mikrostrukturierte Nickel Werkzeugeinsatz 17 (nachfolgend Shim genannt) vom Master 19 getrennt werden. Dazu wird der Master 19 entweder mechanisch vom Shim 17 getrennt oder in einer geeigneten Nassätzchemie oder durch Trockeneätzen aufgelost. Fig. 4 zeigt der getrennte Werkzeugeinsatz 17.

Wie in Fig. 5 gezeigt, wird zum Spritzgiessen eines Kunststoffsteils der Nickel Shim 17 mit den integrierten Lochstempeln 18 in eine Werkzeughälfte 22 eingebaut. Auf der gegenüberliegenden Werkzeughälfte 23 werden Lochstempel 24 eingesetzt, die beim Schliessen des Werkzeuges auf die integrierten Lochstempel 18 auf dem mikrostrukturierten Nickel Shim 17 quetschen. Die eingesetzten Lochstempel 24 werden konventionell gefertigt, da sie auf der unstrukturierten, unkritischen Seite des Kunststoffteils liegen und deshalb die Einpassgenauigkeit nicht so kritisch ist.

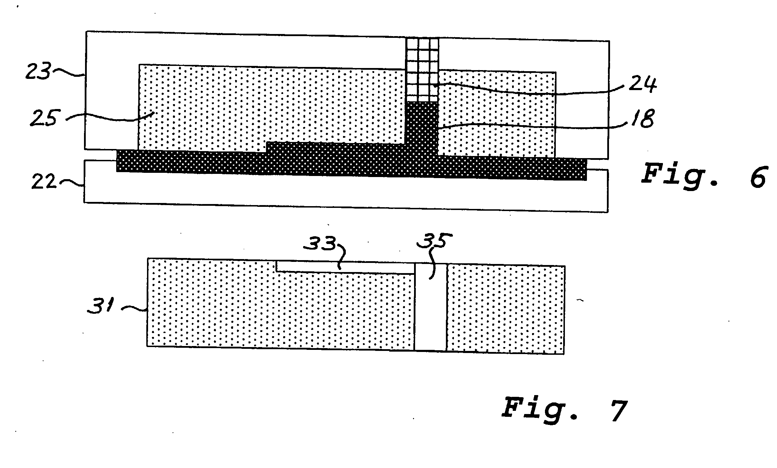

Wie in Fig. 6 gezeigt, drucken beim Schliessen des Spritzgusswerkzeuges die eingesetzten Lochstempel 24 der einen Werkzeughälfte auf die integrierten Lochstempel 18 auf dem Shim 17. Zusätzlich quetscht die Werkzeughälfte mit den eingesetzten Lochstempeln 24 am Rand 21 direkt auf den Shim 17 und definiert so die Aussenkontur des Kunststoffteils 31. An der Stelle der Lochstempel bildet sich beim Einspritzen der Kunststoffschmelze 25 eine Anordnung von Durchgangslöchern 35 im Kunststoffteil 31.

Nach dem Erstarren der Kunststoffschmelze 25 wird das in Fig. 7 schematisch dargestellte Kunststoffteil 31 ausgestossen und entnommen.

Vorteilhaft bei der Verwendung der oben beschriebenen im Werkzeugeinsatz integrierten Lochstempel 18 ist insbesondere, dass die Gefahr der Entstehung von Brauen auf der mikrostrukturierten Seite des Kunststoffteils insbesondere jeweils zwischen Durchgangsloch und Mikrokanal beseitigt wird. Ausserdem können auch kleinste Durchgangslöcher problemlos hergestellt werden.

Die erfindungsgemässe gleichzeitige Erzeugung von integrierten Lochstempeln 18 im Batchverfahren und deren Verwendung beim Spritzgiessen eines Kunststoffsteils 31, der eine Anordnung von Mikrokanälen 33 aufweist, die auf einer im wesentlichen ebene Aussenfläche gebildet werden, und eine Anordnung von Durchgangslöchern 35 aufweist, die sich im wesentlichen senkrecht zur Aussenfläche des Kunststoffsteils 31 erstrecken, ermöglicht grosse Zeit- und Kostenersparnis zu erzielen.

## Patentansprüche

1. Verfahren zur Herstellung eines mikrostrukturierten Werkzeugeinsatzes (17) zum Spritzgiessen eines Teils (31), welches aus einem Kunststoff, einem Metall oder aus einem keramischen Material hergestellt wird und welches eine Anordnung von Mikrokanälen (33) aufweist, die auf einer im wesentlichen ebene Aussenfläche des Teils (31) gebildet werden, und eine Anordnung von Durchgangslöchern (35) aufweist, die sich im wesentlichen senkrecht zur Aussenfläche des Teils (31) erstrecken, welches Verfahren folgende Schritte umfasst
(a) photolithographisches Maskieren der Vorderseite eines ersten Wafers (11) mit einer ersten Ätzmaskierung (12), welche einer Anordnung von Mikrokanälen (13) entspricht,
(b) Mikrostrukturieren der Vorderseite des ersten Wafers (11) mittels Plasmaätzen zur Bildung einer Anordnung von Mikrokanälen (13), welche auf der Vorderseite des Wafers (11) gebildet werden,
(c) Entfernen der ersten Ätzmaskierung (12) von der Vorderseite des ersten Wafers (11),
(d) photolithographisches Maskieren der Rückseite des ersten Wafers (11) mit einer zweiten Ätzmaskierung (14), welche einer Anordnung von im ersten Wafer (11) zu bildenden Durchgangskanälen (15) entspricht,
(e) Mikrostrukturieren der Rückseite des ersten Wafers (11) mittels Plasmaätzen zur Bildung einer Anordnung von Durchgangslöchern (15), die sich im wesentlichen senkrecht zur Vorderseite des ersten Wafers (11) erstrecken,
(f) Entfernen der zweiten Ätzmaskierung (14) von der Rückseite des ersten Wafers (11),
(g) Bonden der Rückseite des ersten Wafers (11) auf ein Trägersubstrat (16) zur Bildung eines Masters (19),
(h) Aufbringen einer elektrisch leitenden Dünnschicht auf der mikrostrukturierten Vorderseite des ersten Wafers (11) und auf den durch die Durchgangskanäle (15) zugänglichen Flächen des Trägersubstrats (16),
(i) elektrochemisches Abscheiden einer Metallschicht (17) auf der Vorderseite des ersten Wafers (11) und in den darin vorhandenen Durchgangskanälen (15), wobei die abgeschiedene Metallschicht (17) eine Tiefe erreicht, die grösser als die Tiefe der Mikrokanäle (13) auf der Vorderseite des ersten Wafers (11) ist,
(j) Planarisieren der Aussenfläche der abgeschiedene Metallschicht (17), und
(k) Trennen der Metallschicht (17) vom Master (19), wobei die abgetrennte Metallschicht (17) als Werkzeugeinsatz (17) zum Spritzgiessen eines Teils (31) verwendbar ist und in der Metallschicht (17) integrierte Lochstempel hat, deren Formen und Abmessungen durch die Formen und Abmessungen von entsprechenden im ersten Wafer (11) vorhandenen Durchgangskanälen (15) definiert sind.

2. Verfahren gemäss Anspruch 1, **dadurch gekennzeichnet, dass** der erste Wafer (11) ein Silizium-Wafer ist.

3. Verfahren gemäss Anspruch 1, **dadurch gekennzeichnet, dass** das Trägersubstrat (16) ein Pyrex-Wafer ist.

4. Verfahren gemäss Anspruch 1, **dadurch gekennzeichnet, dass** das Trägersubstrat (16) ein Silizium-Wafer ist.

5. Verfahren gemäss Anspruch 1, **dadurch gekennzeichnet, dass** die abgeschiedene Metallschicht (17) eine Nickelschicht ist.

6. Verfahren gemäss Anspruch 1, **dadurch gekennzeichnet, dass** die abgeschiedene Metallschicht (17) eine Nickelschicht ist und dass für das elektrochemische Abscheiden dieser Schicht (17) ein Elektrolyt verwendet wird, der ca. 10 % Kobalt enthält.

7. Verfahren zum Spritzgiessen eines Teils (31), welches aus einem Kunststoff, einem Metall oder aus einem keramischen Material hergestellt wird und welches eine Anordnung von Mikrokanälen (33) aufweist, die auf einer im wesentlichen ebene Aussenfläche gebildet werden, und eine Anordnung von Durchgangslöchern (35) aufweist, die sich im wesentlichen senkrecht zur Aussenfläche des Teils (31) erstrecken, wobei ein Werkzeug zum Spritzgiessen verwendet wird, das von einer ersten und einer zweiten Werkzeughälfte (22, 23) gebildet wird, welches Verfahren folgende Schritte umfasst
(a) Einbauen eines ersten Werkzeugeinsatzes (17) in eine erste Werkzeughälfte (22), die zur Formung der Anordnung von Mikrokanälen (33) dient, wobei der erste Werkzeugeinsatz (17) nach einem Verfahren gemäss einem der Ansprüche 1 bis 5 hergestellt wird und eine erste Anordnung von im ersten Werkzeugeinsatz (17) integrierten Lochstempeln hat,
(b) Einbauen eines zweiten Werkzeugeinsatzes in eine zweite Werkzeughälfte (23), die gegenüber der ersten Werkzeughälfte angeordnet wird, wobei der zweite Werkzeugeinsatz eine zweite Anordnung von Lochstempeln (24) hat, welche beim Schliessen des Werkzeugs zum Spritzgiessen auf je einem korrespondierenden Lochstempel (18) der ersten Anordnung drücken,
(c) Schliessen der von den ersten und zweiten Werkzeughälften (22, 23) gebildeten Werkzeugs zum Spritzgiessen,
(d) Einspritzen einer Materialschmelze in den Raum zwischen den ersten und zweiten Werkzeughälften (22, 23),
(f) Abkühlen der eingespritzten Materialschmelze (25), und
(g) Ausstossen aus dem Werkzeug zum Spritzgiessen von einem Teil (31), das durch Erstarrung der eingespritzten Materialschmelze (25) gebildet wird, welches Teil (31) eine Anordnung von Durchgangslöchern (35) aufweist, die beim Spritzgiessen durch die gegeneinander drückenden Lochstempel (18, 24) gebildet werden.

## Claims

1. Method of producing a micro-structured mould insert (17) for injection moulding a part (31) made from a synthetic material, a metal or a ceramic material and which has a pattern of micro-passages (33) which is formed in an essentially flat external surface of the part (31) and has a pattern of end-to-end holes (35) extending essentially perpendicular to the external surface of the part (31), which method comprises the following steps:
(a) photo-lithographically masking the front face of a first wafer (11) with a first etching mask (12) corresponding to a pattern of micro-passages (13),
(b) imparting micro-structures to the front face of the first wafer (11) by plasma etching in order to form a pattern of micro-passages (13) which are formed on the front face of the wafer (11),
(c) removing the first etching mask (12) from the front face of the first wafer (11),
(d) photo-lithographically masking the rear face of the first wafer (11) with a second etching mask (14), which corresponds to a pattern of end-to-end passages (15) to be formed in the first wafer (11),
(e) imparting micro-structures to the rear face of the first wafer (11) by plasma etching in order to form a pattern of end-to-end holes (15) extending essentially perpendicular to the front face of the first wafer (11),
(f) removing the second etching mask (14) from the rear face of the first wafer (11),
(g) bonding the rear face of the first wafer (11) to a support substrate (16) in order to form a master (19),
(h) applying an electrically conductive thin layer to the micro-structured front face of the first wafer (11) and to the surfaces of the support substrate (16) accessible through the end-to-end passages (15),
(i) electro-chemically depositing a metal layer (17) on the front face of the first wafer (11) and in the end-to-end passages (15) created in it, the deposited metal layer (17) reaching a depth which is greater than the depth of the micro-passages (13) on the front face of the first wafer (11),
(j) rendering the external surface of the deposited metal layer (17) planar and
(k) separating the metal layer (17) from the master (19), which separated metal layer (17) can be used as a mould insert (17) for injection moulding a part (31) and has integrated piercing dies in the metal layer (17), the shapes and dimensions of which are defined by the shapes and dimensions of corresponding end-to-end passages (15) which exist in the first wafer (11).

2. Method as claimed in claim 1, **characterised in that** the first wafer (11) is a silicon wafer.

3. Method as claimed in claim 1, **characterised in that** the support substrate (16) is a Pyrex wafer.

4. Method as claimed in claim 1, **characterised in that** the support substrate (16) is a silicon wafer.

5. Method as claimed in claim 1, **characterised in that** the deposited metal layer (17) is a nickel layer.

6. Method as claimed in claim 1, **characterised in that** the deposited metal layer (17) is a nickel layer and an electrolyte containing approximately 10 % of cobalt is used as a means of electro-chemically depositing this layer (17).

7. Method of injection moulding a part (31) made from a synthetic material, a metal or a ceramic material and which has a pattern of micro-passages (33) formed in an essentially flat external surface and a pattern of end-to-end holes (35) extending essentially perpendicular to the external face of the part (31), a mould formed by a first and a second mould half (22, 23) being used for the injection moulding process, which method comprises the following steps:
(a) fitting a first mould insert (17) used to form the pattern of micro-passages (33) in a first mould half (22), which first mould insert (17) is made by a method as claimed in one of claims 1 to 5 and has a first pattern of piercing dies integrated in the first mould insert (17),
(b) fitting a second mould insert in a second mould half (23) disposed opposite the first mould half, which second mould insert has a second pattern of piercing dies (24), each of which pushes against a corresponding piercing die (18) of the first pattern when the mould is closed in order to run the injection moulding process,
(c) closing the mould comprising the first and second mould halves (22, 23) in order to run the injection moulding process,
(d) injecting a material melt into the space between the first and the second mould halves (22, 23),
(f) cooling the injected material melt (25) and
(g) ejecting from the injection-moulding mould a part (31) which is formed by solidifying the injected material melt (25), which part (31) incorporates a pattern of end-to-end holes (35) which are formed by the piercing dies (18, 24) pushing against one another during the injection moulding process.

## Revendications

1. Procédé pour la fabrication d'un insert d'outil (17) microstructuré, pour le moulage par injection d'une pièce (31), qui est fabriquée à base d'un plastique, d'un métal ou d'un matériau céramique et lequel présente un agencement de microcanaux (33), qui sont formés sur une surface extérieure sensiblement plane de la pièce (31), et présente un agencement de trous de passage (35), qui s'étendent sensiblement perpendiculairement à la surface extérieure de la pièce (31), lequel procédé comprend les étapes suivantes :
(a) masquage photolithographique du côté avant d'une première tranche (11) avec un premier masquage de décapage (12) qui correspond à un agencement de microcanaux (13),
(b) microstructuration du côté avant de la première tranche (11) par décapage au plasma pour la formation d'un agencement de microcanaux (13) qui sont formés sur le côté avant de la tranche (11),
(c) enlèvement du premier masquage de décapage (12) du côté avant de la première tranche (11),
(d) masquage photolithographique du côté arrière de la première tranche (11) avec un second masquage de décapage (14), qui correspond à un agencement de canaux de passage (15) à former dans la première tranche (11),
(e) microstructuration du côté arrière de la première tranche (11) par décapage au plasma pour la formation d'un agencement de trous de passage (15), qui s'étendent sensiblement perpendiculairement au côté avant de là première tranche (11),
(f) enlèvement du second masquage de décapage (14) du côté arrière de la première tranche (11),
(g) collage du côté arrière de la première tranche (11) sur un substrat porteur (16) pour la formation d'un maître (19),
(h) application d'une couche mince électroconductrice sur le côté avant microstructuré de la première tranche (11) et sur les surfaces, accessibles par les canaux de passage (15), du substrat porteur (16)
(i) dépôt électrochimique d'une couche de métal (17) sur le côté avant de la première tranche (11) et dans les canaux de passage (15) présents à l'intérieur, la couche de métal (17) déposée atteignant une profondeur qui est supérieure à la profondeur des microcanaux (13) sur le côté avant de la première tranche (11),
(j) aplanissement de la surface extérieure de la couche de métal (17) déposée, et
(k) séparation de la couche de métal (17) du maître (19), la couche de métal (17) séparée étant utilisée comme insert d'outil (17) pour le moulage par injection d'une pièce (31) et présentant des poinçons intégrés dans la couche de métal (17), dont les formes et les dimensions sont définies par les formes et dimensions de canaux de passage (15) appropriés et présents dans la première tranche (11).

2. Procédé selon la revendication 1, **caractérisé en ce que** la première tranche (11) est une tranche de silicium.

3. Procédé selon la revendication 1, **caractérisé en ce que** le substrat porteur (16) est une tranche de Pyrex.

4. Procédé selon la revendication 1, **caractérisé en ce que** le substrat porteur (16) est une tranche de silicium.

5. Procédé selon la revendication 1, **caractérisé en ce que** la couche de métal (17) déposée est une couche de nickel.

6. Procédé selon la revendication 1, **caractérisé en ce que** la couche de métal (17) déposée est une couche de nickel et **en ce que**, pour le dépôt électrochimique de cette couche (17), on utilise un électrolyte qui contient environ 10 % de cobalt.

7. Procédé pour le moulage par injection d'une pièce (31), qui est fabriquée à base d'un plastique, d'un métal ou d'un matériau céramique et qui présente un agencement de microcanaux (33) qui sont formés sur une surface extérieure sensiblement plane, et présente un agencement de trous de passage (35), qui s'étendent sensiblement perpendiculairement à la surface extérieure de la pièce (31), un outil étant utilisé pour le moulage par injection, lequel est formé par une première et seconde moitiés d'outil (22, 23), lequel procédé comprend les étapes suivantes :
(a) intégration d'un premier insert d'outil (17) dans une première moitié d'outil (22) qui sert au formage de l'agencement de microcanaux (33), le premier insert d'outil (17) étant fabriqué selon un procédé selon l'une des revendications 1 à 5 et ayant un premier agencement de poinçons intégrés dans le premier insert d'outil (17).
(b) intégration d'un second insert d'outil dans une seconde moitié d'outil (23), qui est disposée en face de la première moitié d'outil, le second insert d'outil présentant un second agencement de poinçons (24) qui, lors de la fermeture de l'outil pour le moulage par injection, appuient chacun sur un poinçon (18) correspondant du premier agencement,
(c) fermeture de l'outil formé des première et seconde moitiés d'outil (22, 23) pour le moulage par injection,
(d) injection d'une masse fondue de matériau dans l'espace situé entre les première et seconde moitiés d'outil (22, 23),
(f) refroidissement de la masse fondue de matériau (25) injectée, et
(g) expulsion de l'outil pour le moulage par injection d'une pièce (31) qui est formée par solidification de la masse fondue de matériau (25) injectée, laquelle pièce (31) présente un agencement de trous de passage (35) qui sont formés lors du moulage par injection par les poinçons (18, 24) s'appuyant les uns contre les autres.
